# EUROPÄISCHE PATENTSCHRIFT

(11) **EP 1 970 970 B1**
(45) Veröffentlichungstag und Bekanntmachung des Hinweises auf die Patenterteilung: **07.12.2016**
(21) Anmeldenummer: 08158704.0
(22) Anmeldetag: 27.07.2001
(51) Int. Cl.: H01L 33/50, C09K 11/08

(54) **Beleuchtungseinheit mit mindestens einer LED als Lichtquelle**
Lighting unit with at least one LED as light source
Unité d'éclairage dotée d'au moins une DEL en tant que source lumineuse

(30) Priorität: 28.07.2000 DE 10036940
(43) Veröffentlichungstag der Anmeldung: 17.09.2008
(62) Teilanmeldung aus: 01956394.9
(73) Patentinhaber: OSRAM GmbH, 80807 München (DE); OSRAM Opto Semiconductors GmbH, 93055 Regensburg (DE)
(72) Erfinder: Bokor, Dieter, 82024 Taufkirchen (DE); Ellens, Andries, 6716 CC Ede (NL); Huber, Günter, 86529 Schrobenhausen (DE); Jermann, Frank, 86343 Königsbrunn (DE); Kobusch, Manfred, 81739 München (DE); Ostertag, Michael, 81549 München (DE); Rossner, Wolfang, 83607 Holzkirchen (DE); Zwaschka, Franz, 85737 Ismaning (DE)
(74) Vertreter: Epping - Hermann - Fischer

(56) Entgegenhaltungen:
- WO-A-00/19546
- WO-A-00/32982
- WO-A-00/33389
- GB-A- 1 208 594
- POORT S H M ET AL: "Optical properties of Eu<2+>-activated orthosilicates and orthophosphates" JOURNAL OF ALLOYS AND COMPOUNDS, ELSEVIER SEQUOIA, LAUSANNE, CH, Bd. 260, Nr. 1, 12. September 1997 (1997-09-12), Seiten 93-97, XP004116136 ISSN: 0925-8388

## Beschreibung

### Technisches Gebiet

Die Erfindung geht aus von einer Beleuchtungseinheit mit mindestens einer LED als Lichtquelle gemäß dem Oberbegriff des Anspruchs 1. Es handelt sich insbesondere um eine im Sichtbaren oder Weißen emittierenden Lumineszenz-Konversions-LED auf der Basis einer primär im nahen UV oder kurzwelligen Blau emittierenden LED.

### Stand der Technik

LED, die weißes Licht abgeben, werden derzeit vorwiegend durch die Kombination einer im Blauen bei etwa 460 nm emittierenden Ga(In)N-LED und eines gelb emittierenden YAG:Ce³⁺-Leuchtstoffs erzeugt (US 5 998 925 und EP 862 794). Allerdings sind diese Weißlicht-LEDs für Zwecke der Allgemeinbeleuchtung wegen ihrer schlechten Farbwiedergabe aufgrund fehlender Farbkomponenten (vor allem der Rot-Komponente) nur eingeschränkt zu gebrauchen. Statt dessen wird auch versucht, primär blau emittierende LED mit mehreren Leuchtstoffen zu kombinieren um die Farbwiedergabe zu verbessern, siehe WO 00/33389 und WO 00/33390, oder eine zum Teil wellenlängenkonvertierte blau emittierende LED mit einer zweiten LED Primärlichtquelle zu kombinieren, siehe WO 00/19546.

Grundsätzlich ist außerdem bekannt, weiß emittierende LEDs auch mit sogenannten organischen LEDs zu realisieren oder durch Zusammenschalten monochromer LEDs mit entsprechender Farbmischung. Meist wird eine UV LED (Emissionsmaximum zwischen 300 und 370 nm) verwendet, die mittels mehrerer Leuchtstoffe, meist drei, die im roten, grünen und blauen Spektralbereich emittieren (RGB-Mischung) in weißes Licht umgewandelt werden (WO 98 39 805, WO 98 39 807 und WO 97 48 138). Als blaue Komponente sind als anorganische Leuchtstoffe BaMgAl₁₀O₁₇:Eu" oder ZnS:Ag⁺ bekannt; als blaugrüne Komponente znS:Cu⁺, oder (Zn,Cd)S:Cu⁺, oder ZnSi(Al,Cu)⁺; als rote Komponente Y₂O₂S:Eu²⁺. Außerdem wird eine Reihe organischer Leuchtstoffe empfohlen.

Für weiß emittierenden Quellen von hoher Lichtqualität mit kleinen Dimensionen oder als Hintergrundbeleuchtung von z. B. LCDs sind Leuchtstofflampen und Glühlampen wenig geeignet. OLEDs sind dazu zwar besser geeignet, allerdings ist die UV-Beständigkeit von organischen Leuchtstoffen im Vergleich zu anorganische Leuchtstoffen schlechter. Außerdem sind die Herstellkosten höher. Blaue LED mit dem Leuchtstoff YAG:Ce³⁺ (und davon abgeleiteten Granaten) sind prinzipiell ebenfalls geeignet, jedoch bestehen Nachteile in der Farborteinstellung: Nur in beschränkter Weise kann der Farbort derart gewählt werden, dass Weißes Licht entsteht, das eine gute Farbwiedergabe ermöglicht, da der weiße Farbeindruck primär durch die Mischung blauer Emission der LED und gelber Emission des Leuchtstoffs entsteht. Der Nachteil von Leuchtstofflampen und UV-(O)LEDs besteht darin, dass UV-Energie in sichtbares Licht mit einer schlechten Energieeffizienz umgewandelt wird: UV-Strahlung (in Leuchtstofflampen 254 und 365 nm; in UV LED 300 - 370 nm) einer Wellenlänge von z. B. 254 nm wird umgewandelt in Licht mit einer Wellenlänge von 450-650 nm. Das bedeutet einen Energieverlust von 40 bis 60 % bei einer theoretischen Quanteneffizienz von 100%.

Organische Leuchtstoffe sind im allgemeinen schwieriger herzustellen als anorganische Leuchtstoffe, und sind darüber hinaus im allgemeinen zu instabil, um in Lichtquellen hoher Lebensdauer (z. B. über 30.000 Stunden) eingesetzt werden zu können.

Dieser Stand der Technik hat einige bedeutende Nachteile hinsichtlich der Energieeffizienz der Kombination aus LED und Leuchtstoffen und/oder der Stabilität der Leuchtstoffe und/oder Beschränkungen hinsichtlich der geometrischen Dimensionen.

### Darstellung der Erfindung

Es ist Aufgabe der vorliegenden Erfindung, eine Beleuchtungseinheit mit mindestens einer LED als Lichtquellegemäß dem Oberbegriff des Anspruchs 1 bereitzustellen, die sich durch hohe Effizienz auszeichnet.

Diese Aufgaben werden durch die kennzeichnenden Merkmale des Anspruchs 1 gelöst. Besonders vorteilhafte Ausgestaltungen finden sich in den abhängigen Ansprüchen.

Die Erfindung ist besonders vorteilhaft im Zusammenhang mit der Entwicklung einer im Sichtbaren bzw. Weißen emittierenden LED. Diese LED kann hergestellt werden durch Kombination einer im nahen UV oder sehr kurzwelligem blaues Licht (hier zusammenfassend als "kurzwellig" bezeichnet) emittierenden LED mit einer Emissionswellenlänge zwischen 370 und 430 nm und mindestens einem der unten angeführten Leuchtstoffe, der die Strahlung der LED ganz oder teilweise absorbiert und selbst in Spektralbereichen emittiert, deren additive Mischung mit dem Licht der LED und /oder anderen Farbstoffe weißes Licht mit guter Farbwiedergabe oder Licht mit einem gewünschten Farbort ergibt. Je nach Anwendung kann ein einziger Leuchtstoff mit den erfindungsgemäßen Eigenschaften ausreichen. Evtl. kann er auch mit einem oder mehreren anderen erfindungsgemäßen Leuchtstoffen oder Leuchtstoffen anderer Klassen, beispielsweise vom Typ YAG:Ce, kombiniert werden. Das blaue Licht der LED ist hier nicht (oder kaum) direkt nutzbar, im Gegensatz zum Stand der Technik, der längerwelliges Blau (430 bis 480 nm) verwendet, sondern eignet sich nur zur primären Anregung der Leuchtstoffe.

Eine primäre Strahlungsquelle, deren Emission viel näher an der Wellenlänge liegt, bei der die Leuchtstoffe emittieren, kann die Energieeffizienz erheblich steigern. Bei einer Quelle, die bei 400 nm emittiert, reduziert sich zum Beispiel der Energie-Verlust schon auf nur noch 12 bis 39%.

Das technische Problem liegt in der Entwicklung und Produktion ausreichend effizienter Leuchtstoffe, die im spektralen Bereich zwischen 370 nm und 430 nm anregbar sind und gleichzeitig ein passendes Emissionsverhalten zeigen.

Um eine farbige oder weiße LED zu realisieren, wird ein erfindungsgemäßer Leuchtstoff, evtl. in Verbindung mit einem oder mehreren anderen Leuchtstoffen mit einem möglichst transparenten Bindemittel kombiniert (EP 862 794). Der Leuchtstoff absorbiert das Licht der UV/Blau-Licht emittierenden LED ganz oder teilweise und emittiert es in anderen Spektralbereichen wieder breitbandig, so dass eine Gesamtemission mit gewünschtem Farbort entsteht. Bisher gibt es kaum Leuchtstoffe, die diese Anforderungen so gut erfüllen wie die hier beschriebenen Leuchtstoffe. Sie zeigen eine hohe Quanteneffizienz (typisch 70 %) und gleichzeitig eine spektrale Emission, die aufgrund der Empfindlichkeit des Auges als hell empfunden wird. Der Farbort lässt sich in einem weiten Bereich einstellen. Zu den Vorteilen dieser Leuchtstoffe zählen außerdem ihre relativ leichte, umweltschonende Herstellbarkeit, seine Ungiftigkeit und seine relativ hohe chemische Stabilität.

Die Erfindung betrifft insbesondere eine Beleuchtungseinheit mit mindestens einer LED als Lichtquelle (light emitting diode), die besondere spezifisch gewünschte Farbtöne erzeugt (beispielsweise Magenta) oder die beispielsweise weißes Licht erzeugt, indem eine primär kurzwellig (also UV bis blau im Bereich 370 bis 430 nm) emittierende Strahlung mittels mehrerer Leuchtstoffen in Weiß konvertiert wird: entweder durch Mischung der sekundären Strahlung eines blau und gelb emittierenden Leuchtstoffs oder insbesondere durch RGB-Mischung aus drei Leuchtstoffen die rot, grün und blau emittieren. Für besonders hohe Anforderungen an die Farbwiedergabe können auch mehr als drei Leuchtstoffe kombiniert werden. Zu diesem Zweck kann auch einer der erfindungsgemäß eingesetzten Leuchtstoffe mit anderen, bereits für diese Verwendung bekannten Leuchtstoffen wie beispielsweise SrS:Eu (WO 00/33390) oder YAG:Ce (US 5 998 925) kombiniert werden.

Als primär kurzwellig emittierende LED eignet sich insbesondere eine Ga(In,Al)N-LED, aber auch jeder andere Weg zur Erzeugung einer kurzwelligen LED mit einer primären Emission im Bereich 370 bis 430 nm.

Die Erfindung erweitert die spektrale Emissionscharakteristik von LEDs indem über den gegenwärtige Kenntnisstand hinaus weitere Leuchtstoffe und deren Mischungen Anwendung finden (siehe Tab. 1 bis 3). Dabei kann die Auswahl der angewendeten Leuchtstoffe und Mischungen hiervon so getroffen werden, das neben farbechten Weiß auch andere Mischfarben mit breitbandiger Emission erzeugt werden. Generell wird das emittierte Licht der LED von der Mischung, die Leuchtstoffe enthält, absorbiert. Diese Mischung ist entweder direkt auf der LED aufgebracht oder in einem Harz oder Silikon dispergiert oder aufgebracht auf einer transparenten Scheibe über einer LED oder aufgebracht auf einer transparenten Scheibe über mehreren LEDs.

Der erfinderische Schritt besteht darin, dass durch die Verwendung von LEDs mit Emissionswellenlängen zwischen 370 und 430 nm (unsichtbar oder kaum sichtbares tiefblau) und die Verwendung von Leuchtstoffen, die unten aufgelistet sind, eine verbesserte spektrale Anpassung der LED-Emission ermöglicht wird und beliebige Farborte einstellbar werden, und zwar mit einer höheren Energieeffizienz als mit den konventionellen LEDs.

Anorganische Leuchtstoffe, die relativ langweilig anregbar sind, sind derzeit kaum bekannt. Überraschenderweise hat sich jedoch gezeigt, dass es eine Anzahl von anorganischen Leuchtstoffen gibt, die geeignet sind, um mit Strahlung einer Peak-Emissions-Wellenlänge von 370-430 nm noch effizient angeregt zu werden. Typische Halbwertsbreiten der Emission liegen bei 20 nm bis 50 nm. Die Absorption der Leuchtstoffe kann durch die gewählten Strukturparameter und chemische Zusammensetzung gesteuert werden. Solche Leuchtstoffe haben alle eine relativ kleine Bandlücke (typisch etwa 3 eV) oder sie haben ein starkes Kristallfeld für das lon, welches das von der LED emittierte UV/Blau -Licht um 400 nm absorbiert.

Abhängig von der gewählten Lumineszenzwellenlänge der LED (370-430 nm) und abhängig von der gewünschten Farbwiedergabe und /oder dem gewünschten Farbort können bestimmte Kombinationen von Leuchtstoffen in der Leuchtstoffmischung gewälzit werden. Die am besten geeignete Leuchtstoffmischung ist somit vom gewählten Ziel (Farbwiedergabe, Farbort, Farbtemperatur) und der vorhandenen LED-Emissionswellenlänge abhängig.

Jeder Leuchtstoff, der die oben erwähnten Bedingungen erfüllt, ist im Prinzip geeignet für die Anwendung. Leuchtstoffe, die effizient emittieren und im Gebiet von 370-430 nm effizient anregbar oder zumindest teilweise anregbar sind, sind in den folgenden Tabellen aufgeführt. Tab. 1 beschreibt geeignete blaue Leuchtstoffe mit einer Wellenlänge der Peakemission von 440 bis 485 nm, Tab. 2 geeignete grüne Leuchtstoffe mit einer Wellenlänge der Peakemission von 505 bis 550 nm und Tab. 3 geeignete rote Leuchtstoffe mit Wellenlänge der Peakemission von 560 bis 670 nm. Damit ist es erstmals möglich, LED mit hoher Effizienz herzustellen, die auf einer kurzwellig emittierenden Diode basieren, die mehrere Leuchtstoffe anregt.

**Tabelle 1: Blau emittierende Leuchtstoffe:**

| | |
|---|---|
| M₅(PO₄)₃(X).Eu¹⁺ | mit M = zumindest eines der Metalle Ba, Ca allein oder in Kombination mit Sr (bevorzugt ist Anteil Sr höchstens 85%), wobei X = zumindest eines der Halogene F oder Cl; |
| | |
| M*3MgSi2O8:Eu2+ | mit M = zumindest eines der Metalle Ba, Ca, Sr allein oder in Kombination |
| | |
| Ba₅SiO₄Br₆:Eu²⁺ | |
| | |
| Ba_{1.29}Al₁₂O_{19.19}:Eu²⁺ | |
| | |
| YSiO₂N:Ce³⁺ | |
| | |
| (Sr,Ba)₂Al₆O₁₁:Eu²⁺ | |
| | |
| MF₂:Eu²⁺ | mit M = zumindest eines der Metalle Ba, Sr, Ca; bevorzugt ist der Anteil des Ba an M > 5 %, beispielsweise Ba = 10 %, also M = Ba_{0.10}Sr_{0.45}Ca_{0.45}. |
| | |
| Ba_{0.57}Eu_{0.34}Al_{11.11}O₁₇:Zu²⁺ | |
| | |
| M**MgA110O17.Eu2+ | mit M** = zumindest eines der Metalle Eu, Sr allein oder in Kombination mit Ba (bevorzugt ist Anteil Ba höchstens 75%); |
| | |
| MLn2S4:Ce³⁺ | mit M = eine Kombination der Metalle Ca, Sr; und In = zumindest eines der Metalle La, Y, Gd. |

**Tabelle 2: Grün (und Blaugrün) emittierende Leuchtstoffe**

| | |
|---|---|
| SrAl₂O₄:Eu²⁺ | |
| | |
| MBO3:(Ce3+,Tb3+) | mit M = zumindest eines der Metalle Sc, Gd, Lu allein oder in Kombination mit Y (imsb. ist Y-Anteil < 40%); und als Aktivator fungieren die Metalle Ce und Tb gemeinsam; insbesondere liegt der Anteil des Ce am Metall M im Bereich 5 % ≤ Ce ≤ 20 % und der Anteil des Tb am Metall im Bereich 4 % ≤Tb ≤ 20; bevorzugt ist Anteil Ce > Anteil Tb; |
| | |
| M2SiO5:(Ce3+,Tb3+) | mit M = zumindest eines der Metalle Y, Gd, Lu; und als Aktivator fungieren die Metalle Ce und Tb gemeinsam (bevorzugt ist Anteil Ce> Anteil Tb); |
| | |
| MN*2S4:Ak | mit M = zumindest eines der Metalle Zn, Mg, Ca, Sr, Ba; mit N = zumindest eines der Metalle Al, Ga, In; und Ak = entweder eine Kombination von Eu2+, Mn2 zusammen (bevorzugt ist Anteil Eu > Anteil Mn) oder eine Kombination von Ce3+,Tb3+ zusammen (bevorzugt ist Anteil Ce> Anteil Tb); |
| | |
| SrBaSiO₄:Eu²⁺ | |
| | |
| Ba_{0.02}AlₙO_{18.82}:Eu²⁺ | |
| | |
| Ba_{0.82}Al_{18.82}:Eu²⁺,Mn²⁺ | |
| | |
| Y₅(SiO₄)₃N:Ce³⁺; | |
| | |
| Ca8Mg(SiO4)4Cl2:Ak2+ | mit Ak = Eu2+ allein oder mit Mn2 zusammen (bevorzugt ist Anteil Eu > 2xAnteil Mn); |
| | |
| Sr4Al14O25:Eu2+ | |
| | |
| (Ba,Sr)MgAl10O17:Ak | mit Ak = Eu2+ entweder in Kombination mit Ce3+ und Tb3+, oder in Kombination mit Mn2+ ; bevorzugt ist Anteil Eu am Aktivator Ak > 50 %; |
| | |
| Sr₆BP₅O₂₀:Eu2+ | |
| | |
| Sr₂P₂O₇:(Eu²⁺,Tb³⁺) mit Eu und Tb gemeinsam | |
| | |
| BaSi₂O₅:Eu²⁺ | |

**Tabelle 3: Rot (Orangerot bis Tiefrot) emittierende Leuchtstoffe**

| | |
|---|---|
| Ln₂O₂St:Ak3+ | wobei Ln = zumindest eines der Metalle Gd, La, Leu allein oder in Kombination mit Y (bevorzugt ist Anteil Y höchstens 40%; insbesondere ist Anteil La mindestens 10 %); und mit St = zumindest eines der Elemente S, Se, Te; und wobei Ak = Eu allein oder in Kombination mit Bi; |
| | |
| Ln2WmO6:Ak3+ | wobei Ln = zumindest eines der Metalle Y, Gd, La, Lu; und mit Wm = zumindest eines der Elemente W, Mo, Te; und wobei Ak = Eu allein oder in Kombination mit Bi; |
| | |
| (Zn,Cd)S:Ag+ | wobei Zn und Cd nur in Kombination verwendet werden; bevorzugt ist Anteil Zn < Anteil Cd; |
| | |
| Mg₂₈Ge_{7.5}O₃₈F₁₀:Mn⁴⁺ | |
| | |
| Sr₃P₂O₇:Eu²⁺Mn²⁺ | |
| | |
| Sr₂P₂O₇:Eu²⁺,Mn²⁺ | |
| | |
| M₃MgSi₂O₈:Eu²⁺,Mn²⁺ | mit M = zumindest eines der Metalle Ca, Ba, Sr, |
| | |
| (M1)2(M2)(BO3)2:Eu2+ | mit M1 = zumindest eines der Metalle Ba, Sr; und mit M2 ist zumindest eines der Metalle Mg,Ca; bevorzugt ist der Anteil Ba am Kation M1 mindestens 80 %; bevorzugt ist der Anteil Mg am Metall M2 mindestens 70%. |

Es wird angemerkt, dass der Aktivator im allgemeinen jeweils einen Anteil des führenden Kations (= Metall, insbesondere ein Lanthanid Ln) ersetzt, beispielsweise steht MS:Eu(5 %) für M_{3-0,05}Eu_{0,05}S.

Die Formulierung "M = zumindest eines der Metalle X, Y;" bedeutet entweder das Metall X oder das Metall Y allein oder aber eine Kombination beider Metalle, also M = XₐY_{b} mit a+b = 1.

Bei einer weißen LED wird ein Aufbau ähnlich wie im eingangs erwähnten Stand der Technik beschrieben verwendet. Als UV-Diode (primäre Strahlungsquelle) wird bevorzugt GalnN oder GaN oder GalnAlN verwendet. Beispielsweise hat sie eine Peakwellenlänge von 400 nm und eine Halbwertsbreite von 20 nm. Das Diodensubstrat wird mit einer Suspension aus drei Leuchtstoffen, je einer mit einem Emissionsmaximum im Roten, Grünen und Blauen Spektralbereich direkt oder indirekt beschichtet. Von diesen Leuchtstoffen ist zumindest einer ausgewählt aus den Tabellen 1 bis 3, und kombiniert entweder mit bekannten Leuchtstoffen oder mit Leuchtstoffen aus den anderen Tabellen. Die Leuchtstoffmischung wird bei etwa 200 °C engebrannt. Damit wird eine Farbwiedergabe von typisch 80 erzielt.

Im folgenden soll die Erfindung anhand mehrerer Ausführungsbeispiele näher erläutert werden. Es zeigen:
- Figur 1: ein Halbleiterbauelement, das als Lichtquelle (LED) für weißes Licht dient;
- Figur 2: eine Beleuchtungseinheit mit Leuchtstoffen gemäß der vorliegenden Erfindung;

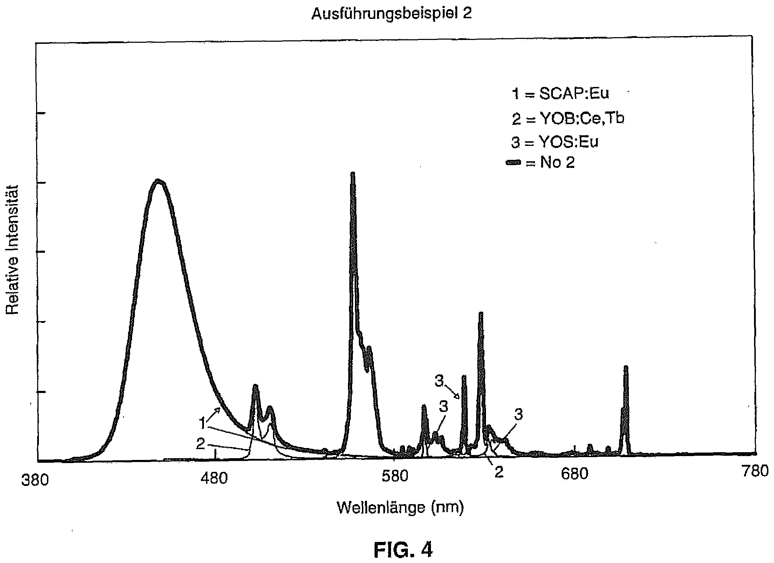

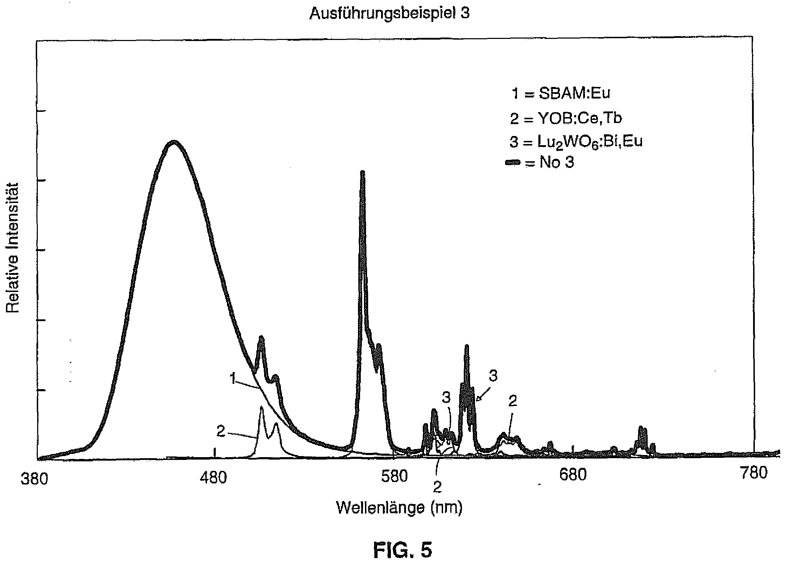

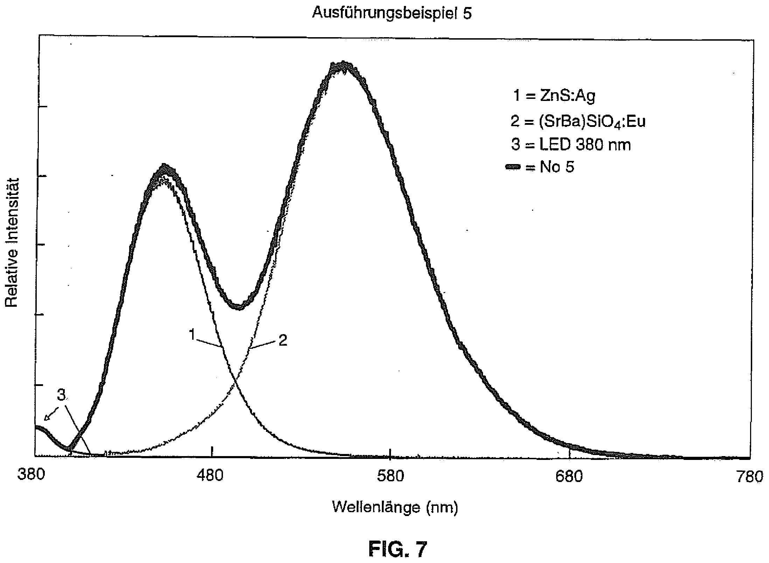

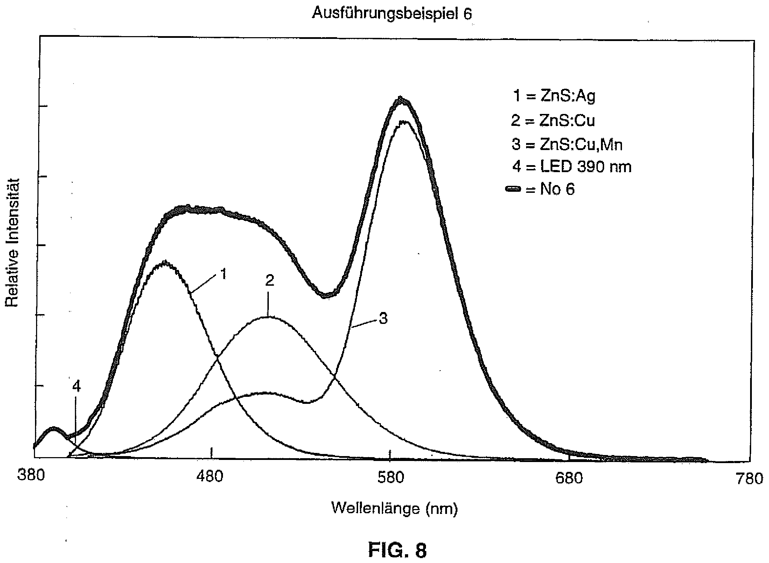

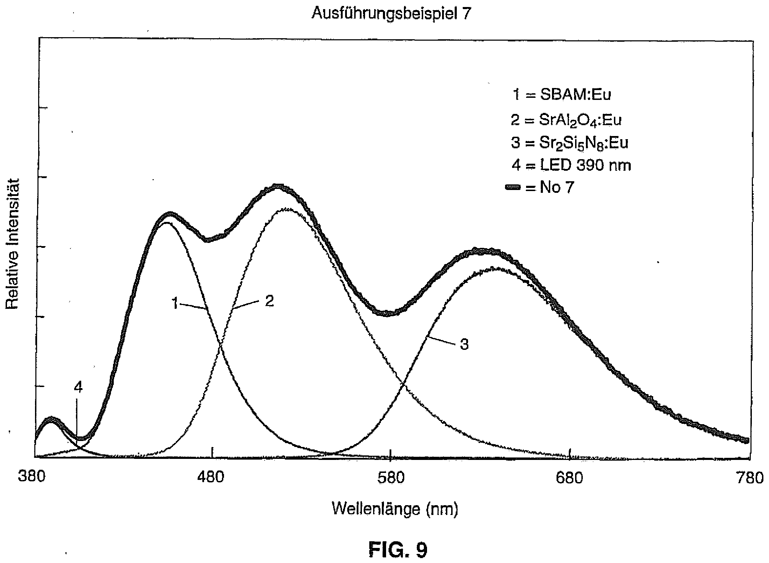

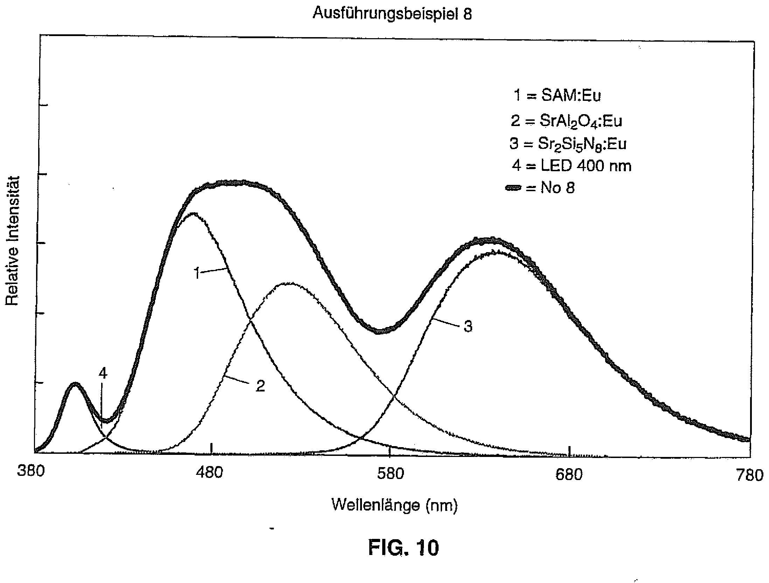

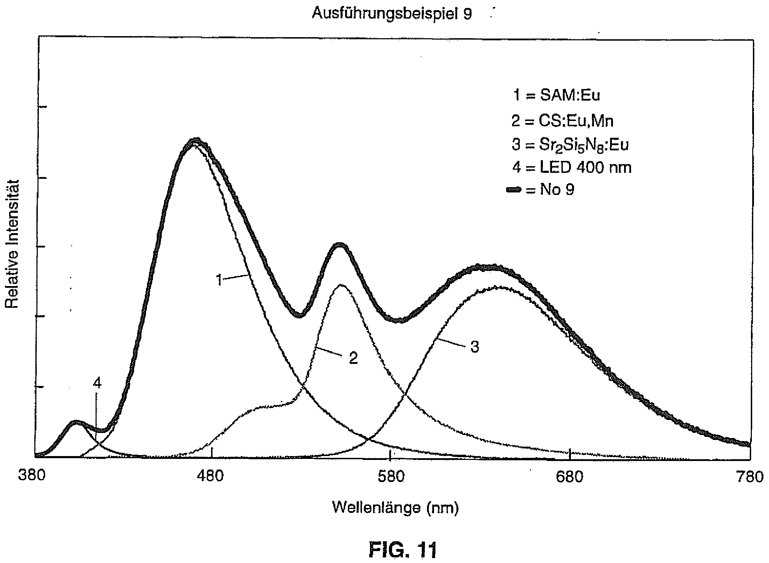

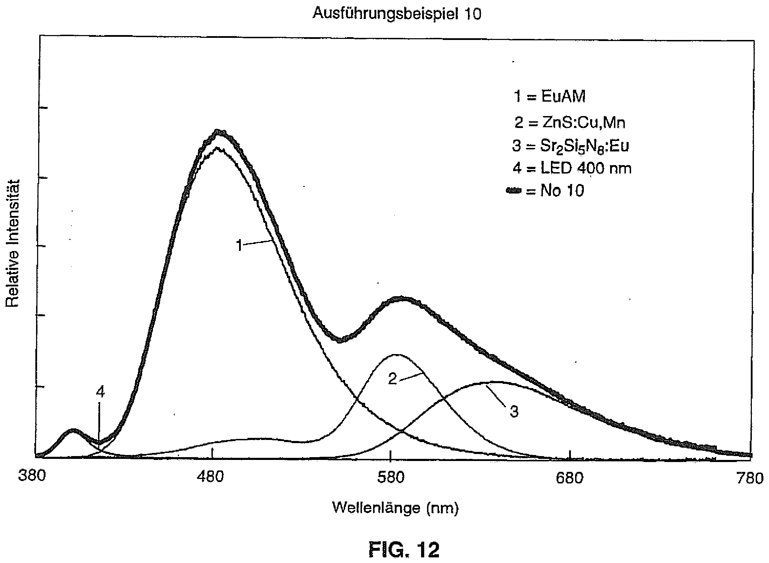

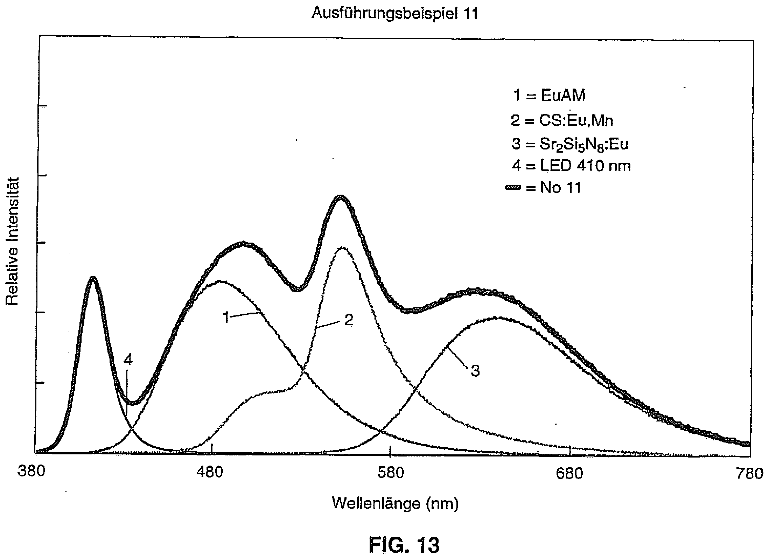

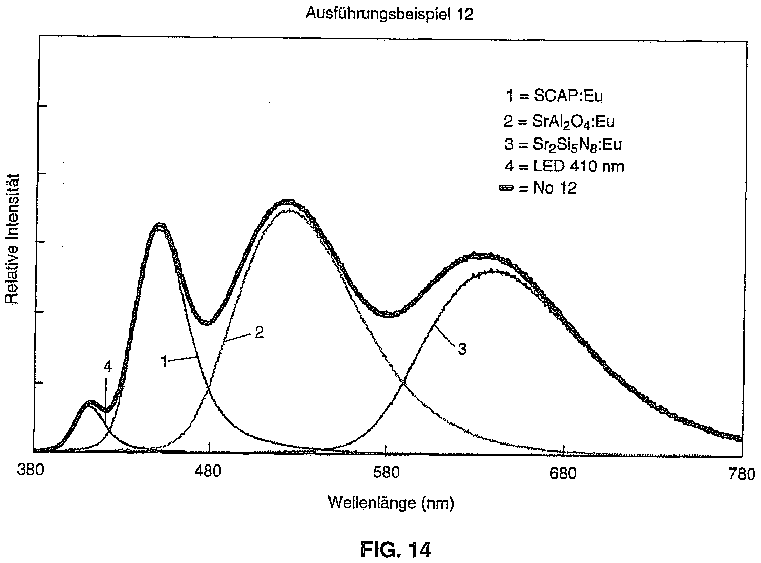

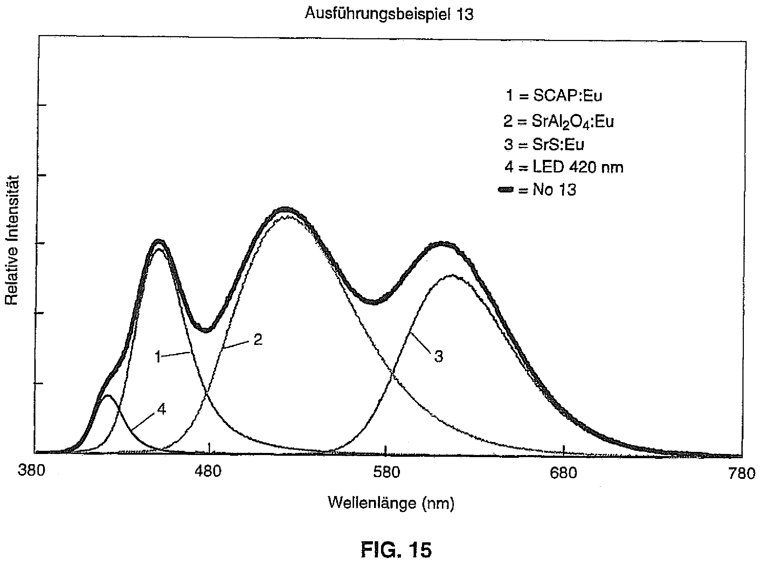

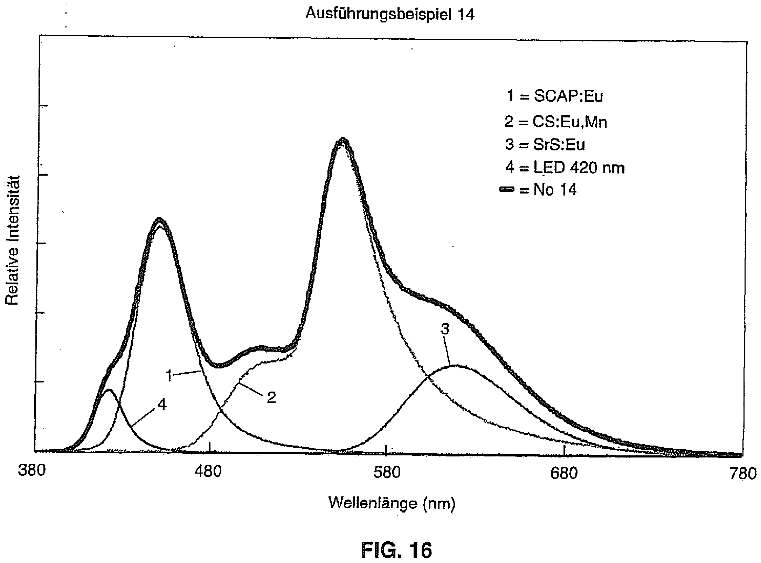

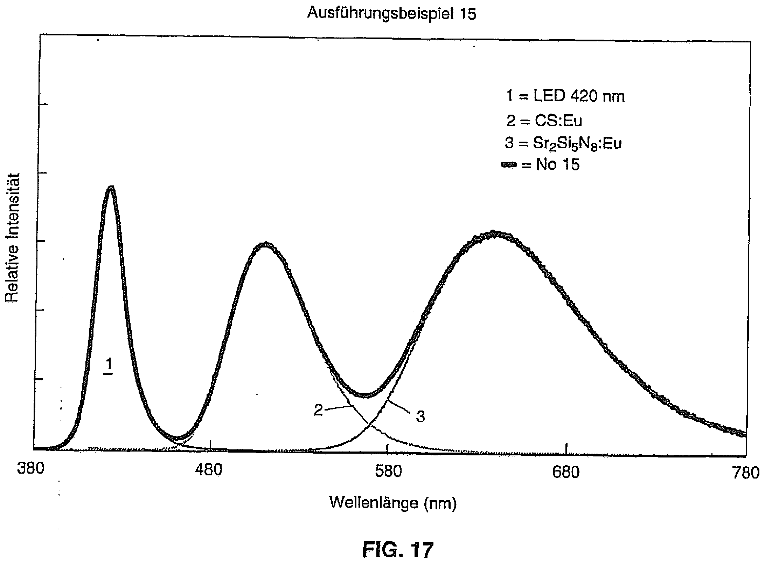

- Figur 3 bis 17: das Emissionsspektrum von LEDs mit verschiedenen Leuchtstoffmischungen gemäß der vorliegenden Erfindung.

### Beschreibung der Zeichnungen

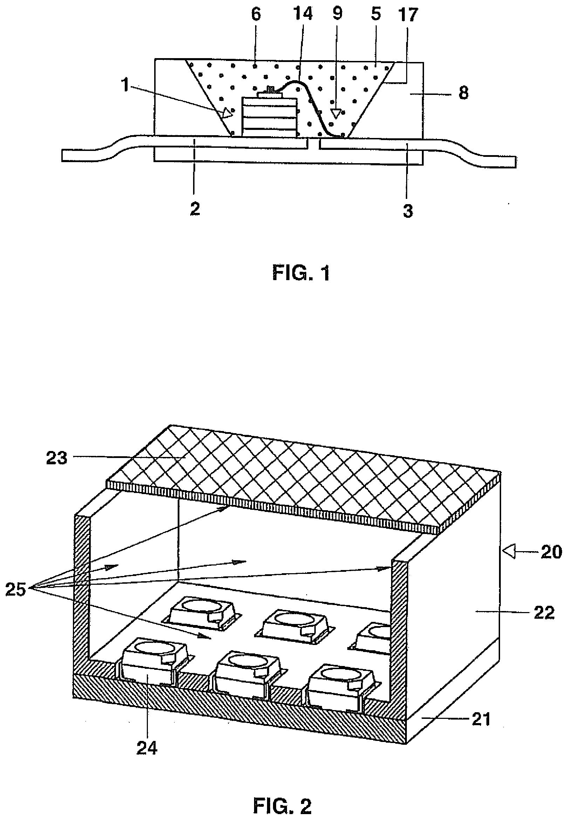

Für den Einsatz in einer weißen LED zusammen mit einem GalnN-Chip wird beispielsweise ein Aufbau ähnlich wie in US 5 998 925 beschrieben verwendet. Der Aufbau einer derartigen Lichtquelle für weißes Licht ist in Figur 1 explizit gezeigt. Die Lichtquelle ist ein Halbleiterbauelement (Chip 1) des Typs InGaN mit einer Peak-Emissionswellenlänge von 420 nm und einer Halbwertsbreite von 25 nm mit einem ersten und zweiten elektrischen Anschluss 2,3, das in ein lichtundurchlässiges Grundgehäuse 8 im Bereich einer Ausnehmung 9 eingebettet ist. Einer der Anschlüsse 3 ist über einen Bonddraht 14 mit dem Chip 1 verbunden. Die Ausnehmung hat eine Wand 17, die als Reflektor für die blaue Primärstrahlung des Chips 1 dient. Die Ausnehmung 9 ist mit einer Vergussmasse 5 gefüllt, die als Hauptbestandteile ein Epoxidgießharz (80 bis 90 Gew.-%) und Leuchtstoffpigmente 6 (weniger als 15 Gew.-%) enthält. Weitere geringe Anteile entfallen u.a. auf Methylether und Aerosil. Die Leuchtstoffpigmente sind eine Mischung. Der erste Konversions-Leuchtstoff ist aus Tab. 1 ausgewählt. Der zweite Leuchtstoff ist aus Tab. 2 und der dritte aus Tab. 3 ausgewählt.

In Figur 2 ist ein Ausschnitt aus einer Flächenleuchte 20 als Beleuchtungseinheit gezeigt. Sie besteht aus einem gemeinsamen Träger 21, auf den ein quaderförmiges äußeres Gehäuse 22 aufgeklebt ist. Seine Oberseite ist mit einer gemeinsamen Abdeckung 23 versehen. Das quaderförmige Gehäuse besitzt Aussparungen, in denen einzelne Hafbleiter-Bauelemente 24 untergebracht sind. Sie sind UVemittierende Leuchtdioden mit einer Peakemission von 380 nm. Die Umwandlung in weißes Licht erfolgt mittels Konversionsschichten, die direkt im Gießharz der einzelnen LED sitzen ähnlich wie in Figur 1 beschrieben oder Schichten 25, die auf allen der UV-Strahlung zugänglichen Flächen angebracht sind. Dazu zählen die innen liegenden Oberflächen der Seitenwände des Gehäuses, der Abdeckung und des Bodenteils. Die Konversionsschichten 25 bestehen aus drei Leuchtstoffen, die im gelben, grünen und blauen Spektralbereich emittieren unter Benutzung zumindest einen der erfindungsgemäßen Leuchtstoffe aus Tab. 1 bis 3.

Einige konkrete Ausführungsbeispiele von in Kombination untersuchten Leuchtstoffen sind in Tab. 4 zusammengefasst. Es handelt sich um eine Zusammenfassung geeigneter erfindungsgemäßer und an sich bekannter Leuchtstoffe in allen drei Spektralbereichen. In Sp. 1 ist die Versuchsnummer angegeben, in Sp. 2 die chemische Formel des Leuchtstoff, in Sp. 3 das Emissionsmaximum des Leuchtstoffs, in Sp. 4 und 5 die x- und y- Farbortkoordinaten. In Sp. 6 und 7 sind die Reflektivität und die Quanteneffizienz (jeweils in Prozent) angegeben.

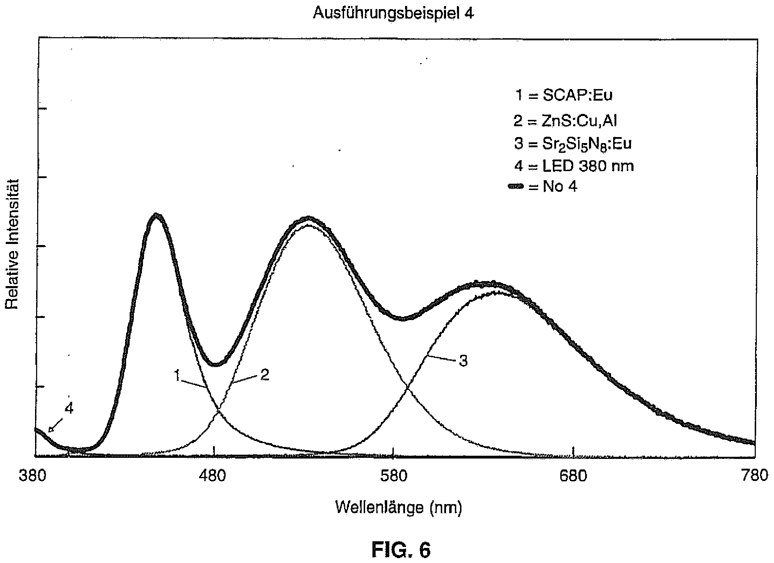

Besonders bevorzugt ist auch die Anwendung der ZnS-Leuchtstoffe für LEDs. Sie zeigen ein gutes Verarbeitungsverhalten in der LED-Umgebung. Es handelt sich dabei vor allem um den blau emittierenden Leuchtstoff ZnS:Ag, den grün emittierenden Leuchtstoff ZnS:Cu,Al und den rot emittierenden Leuchtstoff ZnS:Cu,Mn aus Tab. 4. Besonders hervorzuheben ist, dass sich mit diesen drei Leuchtstoffen eine weiß emittierende Leuchtstoff-Mischung realisieren lässt, unter Anregung durch eine LED mit Primärstrahlung im Bereich 370 bis 410 nm, siehe Ausführungsbeispiel 6 in Fig. 6. Da diese drei Leuchtstoffe chemisch nahezu identische Materialien sind, lassen sie sich sehr gut als Leuchtstoffmischung in einem Gießharz oder anderem Harz oder bei einer Beschlämmung verarbeiten.

**Tab. 4**

| *Nr. Formel* | *Em* | *x* | *y* | *R (%)* | *Q*.*E* (%) |
|---|---|---|---|---|---|
| 1 Ba₃MgS₂O₈:Eu(5%) | 440 | 0,16 | 0,07 | 42 | 50 |
| 2 (Ba_{0.15}Sr_{0.85})₅(PO₄)₃Cl:Eu2+ | 448 | 0,15 | 0,05 | 46 | 76 |
| 3 ZnS:Ag | 452 | 0,14 | 0,07 | 76 | 63 |
| 4 (Ba,Sr)MgAl₁₀O₁₇:Eu2+ | 454 | 0,15 | 0,08 | 49 | 83 |
| 5 SrMgAl₁₀Oᵢ₇:Eu2+ | 467 | 0,15 | 0,19 | 63 | 92 |
| 6 EuMgAl₁₀O₁₇ | 481 | 0,17 | 0,31 | 35 | 63 |
| 7 ZnS:Cu | 506 | 0,19 | 0,43 | 22 | 48 |
| 8 Ba_{0.74}Eu_{0.08}Al₁₂O_{18.82} | 507 | 0,22 | 0,43 | 52 | 87 |
| 9 C₃₅Mg(SiO₄)₄Cl₂:Eu2+ | 508 | 0,17 | 0,6 | 34 | 67 |
| 10 ZnS:Cu | 510 | 0,2 | 0,46 | 16 | 55 |
| 11 BaMgAl₁₀CO₇:Eu2+,Mn2+ | 513 | 0,14 | 0,21 | 64 | 95 |
| 12 Ba_{0.72}Eu_{0.05}Mn_{0.05}Al₁₂O_{18.82} | 514 | 0,21 | 0,48 | 71 | 97 |
| 13 BaMgAg₁₀O₁₇:Eu2+,Mn2+ | 515 | 0,14 | 0,65 | 39 | 88 |
| 14 (Sr,Ba)SiO₄:Eu2+ | 517 | 0,23 | 0,61 | 54 | |
| 15 SrAl₂O₄:Su2+ | 523 | 0,29 | 0,58 | 28 | 77 |
| 16 ZnS:Cu₃Al | 534 | 0,31 | 0,61 | 29 | 83 |
| 17 YBO₃:(Ce3+,Tb3+) (9.5%/5%) | 545 | 0,34 | 0,59 | 80 | 69 |
| 18 Ca_{B}Mg(SiO₄)₄Cl2:Eu2+, Min2+ | 550 | 0,38 | 0,57 | 30 | 61 |
| 19 Sr_{1.95}Ba_{0.03}Eu_{0.02}SiO₄ | 563 | 0,44 | 0,53 | 21 | |
| 20 Sr₂P₂O₇:Eu2+, Mn2+ | 570 | 0,32 | 0,27 | 63 | 46 |
| 21 ZnS :Cu,Mn | 585 | 0,49 | 0,45 | 19 | 44 |
| 22 Gd₂MoO₆:Eu3+ (20%) | 610 | 0,66 | 0,34 | 50 | |
| 23 Y₂W_{0.98}Mo_{0.02}O₆:Su³⁺ | 612 | 0,61 | 0,38 | 68 | 73 |
| 24 Y₂WO₆:Eu3+, Bi3+ (7.5%, 0.5%) | 612 | 0,64 | 0,36 | 52 | |
| 25 Lu₂WO₆:Eu3+, Bi3+(7.5%, 1%) | 612 | 0,64 | 0,36 | 65 | |
| 26 SrS:Eu2+ (2%) | 616 | 0,63 | 0,37 | 52 | 91 |
| 27 La₂TeO₆:Eu3+ (%) | 617 | 0,66 | 0,34 | 76 | |
| 28 (La,Y)₂O₂S:Eu3+ (..) | 626 | 0,67 | 0,33 | 84 | 73 |
| 29 Sr₂Si₅N₈:Eu2+ (10%) | 636 | 0,64 | 0,36 | 12 | 70 |
| 30 (Ba,Ca,Sr)MgSi₂O₈: Eu,Mn | 657 | 0,39 | 0,16 | 47 | 52 |

Der Leuchtstoff Nr. 14 (Sr,Ba)SiO₄:Eu2+ ist im Grünen so breitbandig, dass hier auf eine separate Rotkomponente verzichtet werden.

In Tab. 6 sind schließlich 15 Ausführungsbeispiele konkreter Kombinationen von Leuchtstoffen aus Tab. 4 in Verbindung mit einer primären Lichtquelle (UV-LED) mit einem Emissionspeak im Bereich 370 bis 420 nm gezeigt. Die einzelnen UV-Dioden sind in Tab. 5 zusammengefasst, in der der Emissionspeak und der Farbort (soweit definiert, also ab 380 nm) der einzelnen Dioden angegeben ist.

In Sp. 1 bis 4 der Tab. 6 sind die Angaben aus Tab. 4 nochmals eingefügt zum besseren Abgleich. In Sp. 5 bis 10 ist die Brauchbarkeit der einzelnen Leuchtstoffe für Anregung bei verschiedenen Wellenlängen festgehalten und zwar systematisch für die kurzwelligen Dioden mit Emissionspeak bei 370 bis 420 nm in Schritten von 10 nm. Die anschließenden 15 Spalten zeigen konkrete Beispiele (als Ex 1 bis Ex 15 bezeichnet) einer RGB-Mischung, also die Kombination der kurzwelligen LED (die zweite Zeile gibt die gewählte Peakemission an) mit drei Leuchtstoffen aus dem roten, grünen und blauen Spektralbereich. Die in der jeweiligen **Spalte** angegebene Zahl bezeichnet den relativen Anteil an der spektralen Emission.

Bei einer stark kurzwelligen UV-Diode, unter 380 nm, liefert die UV-Diode keinerlei Anteil an der sekundären Emission, auch wegen der starken Absorption durch die drei Leuchtstoffe.

Ab einer primären Emission von 380 nm liefert die Diode jedoch einen kleinen, mit steigender Wellenlänge steigenden Anteil im Blauen zusätzlich zum blauen Leuchtstoff. Dieser Anteil erscheint in der Tab. 5 als zusätzlicher vierter Beitrag.

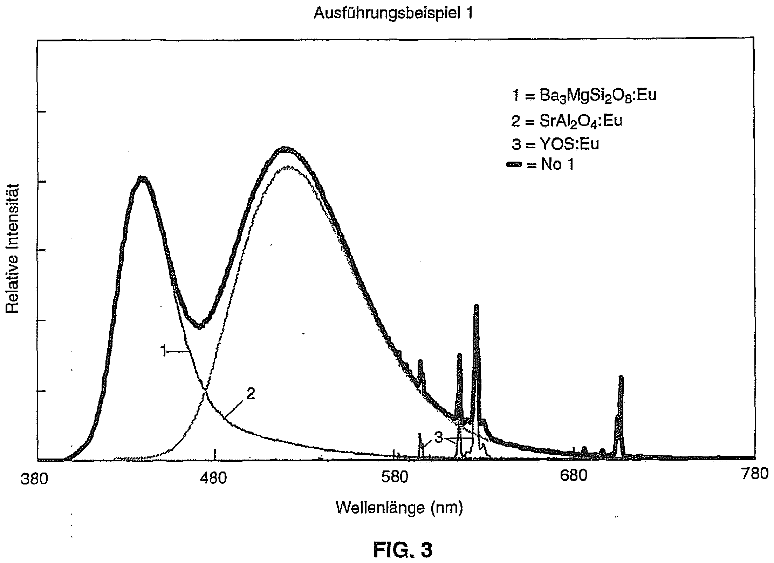

Schließlich sind in den letzten beiden Zeilen der Tab. 6 die gemessenen Farbortkoordinaten des Gesamtsystems eingetragen, die einen weiten Bereich von Weißtönen in der Farbtafel abdecken. Die spektrale Verteilung dieser System ist in den Figuren 3 (entsprechend Ex 1) bis 17 (entsprechend Ex 15) dargestellt.

Als besonders geeignete Leuchtstoffe für die Anwendung in Dreifarbenmischungen unter Primärbestrahlung bei 370 bis 420 nm haben sich dabei die blau emittierenden Leuchtstoffe Nr. 2, 4 und 6, die grün emittierenden Leuchtstoffe 8, 9, 10, 13, 15, 16, 17 und 18 sowie die rot emittierenden Leuchtstoffen 26, 28 und 29 erwiesen.

Das Ausführungsbeispiel Nr. 15 verwendet eine blau emittierende Diode mit 420 nm Peakemission mit so hoher Intensität, dass sie den blauen Leuchtstoff voll ersetzen kann und nur zwei zusätzliche Leuchtstoffe im Grünen und Roten benötigt.

**Tab. 5**

| Nr. | Em | x | y |
|---|---|---|---|
| UV1 | 370 | | |
| UV2 | 380 | 0,2 | 0,14 |
| UV3 | 390 | 0,19 | 0,09 |
| UV4 | 400 | 0,18 | 0,05 |
| UV5 | 410 | 0,18 | 0,03 |
| UV6 | 420 | 0,17 | 0,02 |

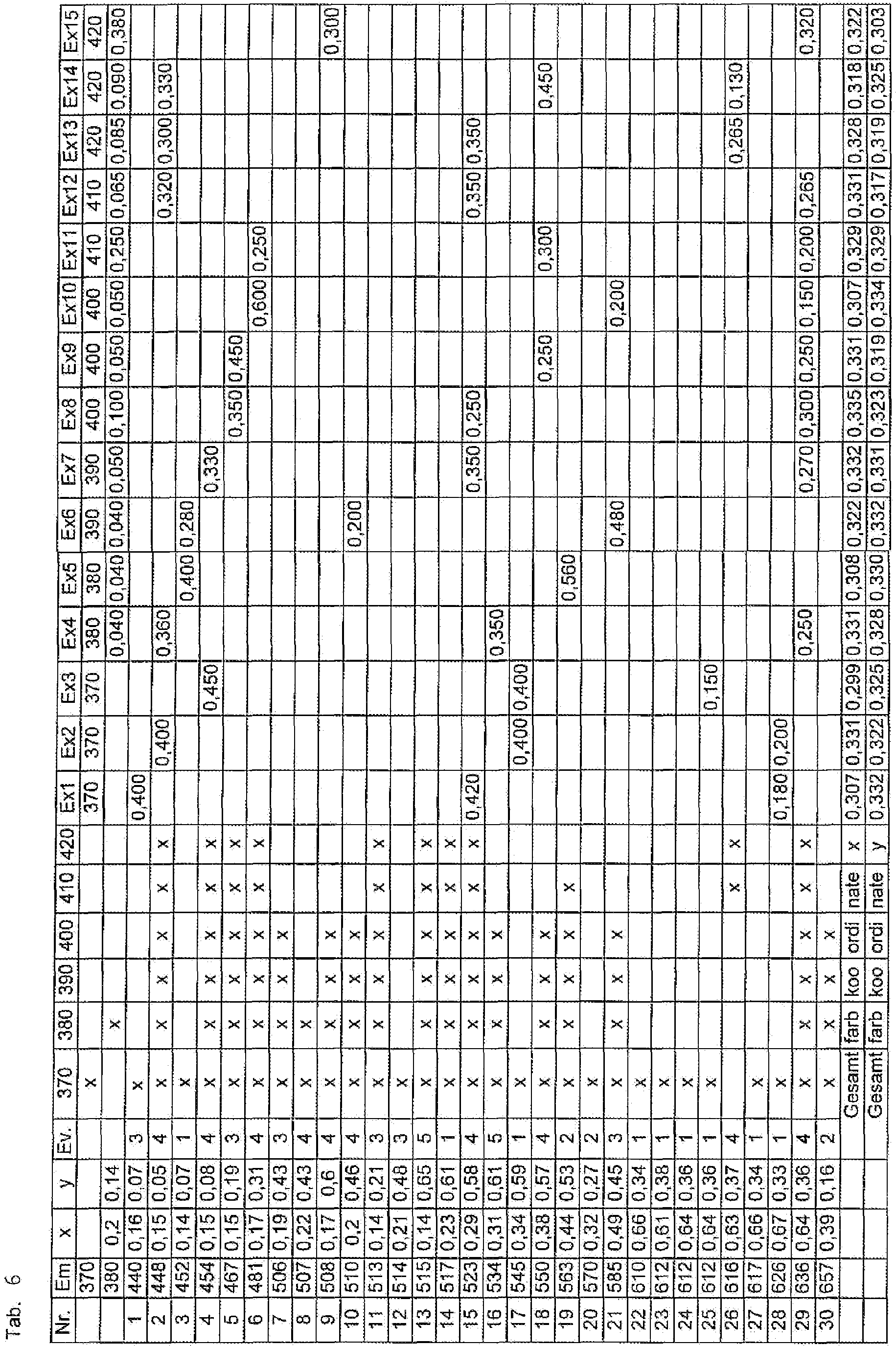

## Patentansprüche

1. Beleuchtungseinheit mit mindestens einer LED als Lichtquelle, wobei die LED eine Lumineszenzkonversions-LED ist, die im sichtbaren Spektralbereich oder die weiß emittiert, wobei die LED primäre Strahlung im Bereich von 370 nm bis 430 nm des optischen Spektralbereichs (Peakwellenlänge) emittiert, wobei diese Strahlung teilweise oder vollständig in Strahlung längerer Wellenlängen durch mindestens einen Leuchtstoff konvertiert wird, **dadurch gekennzeichnet, dass** entweder der Leuchtstoff SrBaSiO₄: Eu²⁺ oder der Leuchtstoff (Sr, Ba)₂ SiO₄:Eu²⁺, der sein Maximum der Emission bei 517 nm aufweist, für die Sekundäremission benutzt wird.

2. Beleuchtungseinheit nach Anspruch 1, **dadurch gekennzeichnet, dass** die Beleuchtungseinheit weißes Licht erzeugt.

3. Beleuchtungseinheit nach Anspruch 1 oder 2, **dadurch gekennzeichnet, dass** die primäre Strahlung durch zumindest einen zweiten Leuchtstoff zusammen mit dem ersten Leuchtstoff konvertiert wird, wobei der zweite Leuchtstoff im blauen, grünen oder roten Spektralbereich emittiert, so dass weißes Licht erzeugt wird, wobei im Fall, dass der Leuchtstoff blaues Licht emittiert, dessen Maximum der Wellenlänge zwischen 440 und 485 nm liegt, und wobei im Fall, dass der Leuchtstoff grünes Licht emittiert, dessen Maximum der Wellenlänge zwischen 505 und 550 nm liegt, und wobei im Fall, dass der Leuchtstoff rotes Licht emittiert, dessen Maximum der Wellenlänge im Bereich 560 bis 670 nm liegt.

4. Beleuchtungseinheit nach Anspruch 3, **dadurch gekennzeichnet, dass** dieser Leuchtstoff im grünen Spektralbereich emittiert und dass ein blauer Leuchtstoff zusätzlich benutzt wird um weißes Licht zu erzeugen.

5. Beleuchtungseinheit nach Anspruch 4, **dadurch gekennzeichnet, dass** zusätzlich ein Leuchtstoff, der rot emittiert, benutzt wird.

6. Beleuchtungseinheit nach Anspruch 1, **dadurch gekennzeichnet, dass** die Beleuchtungseinheit eine farbig oder weiß emittierende LED ist.

7. Beleuchtungseinheit nach Anspruch 6, **dadurch gekennzeichnet, dass** die farbig oder weiß emittierende LED ein möglichst transparentes Bindemittel umfasst.

## Claims

1. Illumination unit having at least one LED as a light source, wherein the LED is a luminescence conversion LED emitting in the visible spectral range or white light, wherein the LED emits primary radiation in the range of 370 nm to 430 nm of the optical spectral range (peak wavelength), wherein this radiation is converted in part or completely to radiation having longer wavelengths by way of at least one phosphor, **characterized in that** either the phosphor SrBaSiO₄:Eu²⁺ or the phosphor (Sr,Ba)₂SiO₄:Eu²⁺, which has its maximum of the emission at 517 nm, is used for the secondary emission.

2. Illumination unit according to Claim 1, **characterized in that** the illumination unit generates white light.

3. Illumination unit according to Claim 1 or 2, **characterized in that** the primary radiation is converted by at least a second phosphor together with the first phosphor, wherein the second phosphor emits in the blue, green or red spectral range such that white light is produced, wherein, if the phosphor emits blue light, the maximum of the wavelength thereof is between 440 and 485 nm, and wherein, if the phosphor emits green light, the maximum of the wavelength thereof is between 505 and 550 nm, and wherein, if the phosphor emits red light, the maximum of the wavelength thereof is in the range of 560 to 670 nm.

4. Illumination unit according to Claim 3, **characterized in that** this phosphor emits in the green spectral range and that a blue phosphor is additionally used to generate white light.

5. Illumination unit according to Claim 4, **characterized in that** a phosphor which emits red is additionally used.

6. Illumination unit according to Claim 1, **characterized in that** the illumination unit is a colour-emitting or white-emitting LED.

7. Illumination unit according to Claim 6, **characterized in that** the colour-emitting or white-emitting LED comprises a binder which is as transparent as possible.

## Revendications

1. Unité d'éclairage dotée d'au moins une DEL en tant que source lumineuse, la DEL étant une DEL de conversion de luminescence, qui émet dans une plage spectrale visible ou en blanc, la DEL émettant un rayonnement primaire dans une plage de 370 nm à 430 nm de la plage spectrale optique (longueur d'onde maximale), ce rayonnement étant converti partiellement ou complètement en un rayonnement de longueurs d'ondes plus longues par au moins une substance luminescente, **caractérisée en ce que** soit la substance luminescente SrBaSiO₄:Eu²⁺ soit la substance luminescente (Sr,Ba)₂SiO₄:Eu²⁺, comportant son maximum d'émission à 517 nm, est utilisée pour l'émission secondaire.

2. Unité d'éclairage selon la revendication 1, **caractérisée en ce que** l'unité d'éclairage produit une lumière blanche.

3. Unité d'éclairage selon la revendication 1 ou 2, **caractérisée en ce que** le rayonnement primaire est converti par au moins une deuxième substance luminescente avec la première substance luminescente, la deuxième substance luminescente émettant dans une plage spectrale bleue, verte ou rouge de sorte que de la lumière blanche est produite, au cas où la substance luminescente émet de la lumière bleue dont la longueur d'ondes maximale se situe entre 440 et 485 nm et au cas où la substance luminescente émet de la lumière verte dont la longueur d'ondes maximale se situe entre 505 et 550 nm et au cas où la substance luminescente émet de la lumière rouge dont la longueur d'ondes maximale se situe dans une plage de 560 à 670 nm.

4. Unité d'éclairage selon la revendication 3, **caractérisée en ce que** cette substance luminescente émet dans la plage spectrale verte et **en ce qu'**une substance luminescente bleue est en plus utilisée pour produire de la lumière blanche.

5. Unité d'éclairage selon la revendication 4, **caractérisée en ce qu'**une substance luminescente est utilisée en plus, qui émet en rouge.

6. Unité d'éclairage selon la revendication 1, **caractérisée en ce que** l'unité d'éclairage est une DEL émettant en couleur ou en blanc.

7. Unité d'éclairage selon la revendication 6, **caractérisée en ce que** la DEL émettant en couleur ou en blanc comprend un liant le plus transparent possible.
